# EUROPÄISCHE PATENTSCHRIFT

(11) **EP 1 087 531 B1**
(45) Veröffentlichungstag und Bekanntmachung des Hinweises auf die Patenterteilung: **30.08.2006**
(21) Anmeldenummer: 00203273.8
(22) Anmeldetag: 19.09.2000
(51) Int. Cl.: H03M 1/18

(54) **Analog-Digital-Wandler mit Verstärkungsregelung für einen Computertomographen**
Gain controlled analogue to digital converter for a computer tomograph
Convertisseur analogique-numérique à règlage de gain pour tomodensitomètre

(30) Priorität: 24.09.1999 DE 19945763
(43) Veröffentlichungstag der Anmeldung: 28.03.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Lauter, Josef, Dr. c/o Philips Corp., 52064 Aachen (DE); Schneider, Stefan, Dr. c/o Philips Corp., 52064 Aachen (DE); Wieczorek, Herfried, Dr. c/o Philips Corp., 52064 Aachen (DE)
(74) Vertreter: Volmer, Georg

(56) Entgegenhaltungen:
- EP-A- 0 297 818
- EP-A- 0 526 028
- EP-A- 0 889 597
- DE-A- 3 634 190
- US-A- 4 292 596
- US-A- 5 177 697

## Beschreibung

Die Erfindung betrifft einen Computertomographen mit einer Strahlungsquelle, einer Detektoranordnung und einem Analog-Digital-Wandler zum Umsetzen der Detektorausgangssignale in Digitalwerte.

Insgesamt erfolgt die Verarbeitung der in der Detektoranordnung empfangenen Photonen, d.h. Licht- oder Röntgenphotonen, in einem Datenaquisitionssystem. In diesem werden die analogen Signale aus den Photosensoren verstärkt und in digitale Signale zur weiteren Verarbeitung umgewandelt.

Aus der OS 36 34 190 ist eine Anordnung für die digitale Radiographie mit einer Bildauf zeichnungseinrichtung bekannt, deren physikalische Parameter durch Röntgenstrahlung änderbar sind, mit einer Detektoranordnung, die diese Änderungen abtastet und in ein elektrisches Signal umsetzt sowie mit einem Analog-Digital-Wandler zum Umsetzen der Detektorausgangssignale in Digitalwerte. Ein derartiger Analog-Digital-Wandler muss einerseits eine relativ hohe Abtastfrequenz aufweisen, um die großen Datenmengen, die in der digitalen Radiographie auftreten können, in annehmbarer Zeit verarbeiten zu können, andererseits muss die Auflösung des Analog-Digital-Wandlers, d. h. die Zahl der Binärstellen, mit denen der Analog-Digital-Wandler den digitalen Abtastwert ausgibt, genügend groß sein, um den vollen Informationsgehalt eines Röntgenbildes übertragen zu können. Die Detektorausgangssignale werden in eine binäre Zahl digitalisiert, deren Betrag durch eine Anzahl von Stellen ausgedrückt wird. Der Zeitaufwand für einen Analog-Digital-Wandler steigt mit der Zahl der pro Abtastwert benötigten Binärstellen. Aus diesem Grund ist es bei der Weiterverarbeitung derartiger binärer Zahlen erwünscht, dass die Anzahl der Bits klein ist. Hierzu schlägt die OS 36 34 190 vor, dass die Digitalwerte jeweils der Quadratwurzel des Detektorausgangssignals proportional sind.

Zur Herstellung dieses nichtlinearen Zusammenhangs zwischen dem digitalen Abtastwert und dem Detektorausgangssignal wird nach der OS 36 34 190 vorgeschlagen, in dem Analog-Digital-Wandler nichtlineare Quantisierungsstufen vorzusehen. Alternativ kann auch ein Analog-Digital-Wandler mit linearer Kennlinie verwendet werden, indem zwischen dem Detektor und dem Analog-Digital-Wandler ein Radizierer angeordnet wird. Ein Nachteil des bekannten Radizierers ist, dass er einen komplizierten Aufbau aufweist und somit empfindlich ist.

Ausgehend von diesem Stand der Technik liegt der Erfindung die Aufgabe zugrunde, einen Computertomographen der eingangs erwähnten Art zu schaffen, bei dem die Anzahl der Binärstellen, die für die Codierung des in den Analog-Digital-Wandler eingehenden Signals notwendig sind, mit insgesamt einfach aufgebauten und mit hoher Zuverlässigkeit arbeitenden Bauelementen reduziert wird.

Diese Aufgabe wird bei einem Computertomographen dadurch gelöst, dass dem Analog-Digital-Wandler ein Ausleseverstärker mit mehreren Verstärkungsfaktoren vorgeordnet wird, und ein Steuersystem für den Verstärkungsfaktor vorgesehen ist, das automatisch bei Erreichen eines vorgegebenen Grenzwertes des integrierten Eingangssignals einen geeigneten Verstärkungsfaktor wählt zur schrittweisen linearen Approximierung an ein proportionales Verhältnis zwischen den Digitalwerten und der Quadratwurzel der Detektorausgangssignale.

Es ist vor dem Analog-Digital-Wandler ein Verstärker mit mehreren Verstärkungsfaktoren vorgesehen, in dem lineare Quantisierungsstufen durchgeführt werden. Durch entsprechend angepasste Wahl der Verstärkungsfaktoren wird eine lineare Approximation der Wurzelfunktion durchgeführt, indem nach Erreichen von vorgegebenen Grenzwerten von integrierter Ladung oder der integrierten Ladung entsprechenden Werten durch Umschalten auf einen entsprechend niedrigeren Verstärkungsfaktor die Wurzelfunktion linear angenähert wird. Die Einstellung der Verstärkungsstufen wird mittels parallel geschalteten Kondensatoren erreicht, die einfach verfügbare Bauelemente darstellen.

Insgesamt zeigt diese Lösung den Vorteil, dass Eingangssignale trotz eines breiten dynamischen Bereichs mit hoher Geschwindigkeit verarbeitet werden können. Es sind zwar Analog-Digital-Wandler bekannt, die auch große Bitzahlen verarbeiten können, beispielsweise 17 Bit oder mehr. Mit zunehmender Bitzahl wird aber ein Analog-Digital-Wandler proportional 2ⁿ langsamer. Indem erfindungsgemäß durch die schrittweise lineare Approximierung an die Wurzelfunktion die individuellen lokalen dynamischen Bereiche des Ausleseverstärkers reduziert werden, beispielsweise auf 12 Bit, ohne Begrenzung des globalen dynamischen Bereichs des Verstärkers, welcher beispielsweise bei 17 Bit liegt, muss der Analog-Digital-Wandler insgesamt nur für 12 Bit ausgelegt sein. Die Geschwindigkeit der Verarbeitung ist demgemäß zu einem 17 Bit Analog-Digital-Wandler schneller, die Endinformation des zu verarbeitenden Signals wird aber nicht eingeschränkt.

Vorteilhaft ist zudem, dass Fehler durch die nicht zu verhindernden Dunkelströme der Photodiode und des Offsets des Verstärkers bei der erfindungsgemäßen Lösung mit einem Verstärker durch mathematische Prozesse korrigiert werden können, was bei dem aus dem Stand der Technik bekannten Radizierer mit entsprechender Wurzelfunktion nicht möglich ist.

Der jeweilige Verstärkungsfaktor wird so gewählt, dass in dem jeweiligen Intervall das Quadratwurzelverhältnis zwischen den Detektorausgangssignalen und den Digitalwerten linear angenähert ist. Insgesamt ist der Grenzwert, von dessen Abhängigkeit das Steuersystem auf einen kleineren Verstärkungsfaktor umschaltet, durch den dynamischen Bereich, der von dem jeweils gewählten Analog-Digital-Wandler verarbeitet werden kann, vorgegeben. Das bedeutet beispielsweise, dass bei einem 12 Bit Analog-Digital-Wandler dieser Grenzwert bei einer integrierten Ladung erreicht ist, deren Signal 12 Bit beträgt. Zudem wird der Analog-Digital-Wandler in Abhängigkeit des Rauschens des kleinsten zu verarbeitenden Signals gewählt. Der Verstärkungsfaktor muss vorzugsweise durch Berechnung so bestimmt werden, dass in dem jeweiligen Intervall das dem jeweils kleinsten Signal entsprechende Rauschen noch erfasst wird und dass die Bitzahl des jeweils größten Signals die Bitzahl, die durch den Analog-Digital-Wandler zu verarbeiten ist, nicht überschreitet.

Nach einer ersten Ausführungsform der Erfindung werden die Verstärker-Eingangssignale als analoge Signale aufsummiert. Bei Erreichen eines vorgegebenen maximalen Grenzwertes der analogen Ausgangsspannung schaltet das Steuersystem auf einen jeweils niedrigeren Verstärkungsgrad um. Nach einer zweiten Ausführungsform der Erfindung findet eine zifferstandabhängige Umschaltung statt, indem die integrierte analoge Ausgangsspannung durch eine Ziffer ausgedrückt wird. Bei beiden Ausführungsformen wird die Ausgangsspannung des Verstärkers bzw. der Ziffernwert in dem Analog-Digital-Wandler in ein digitales Signal umgewandelt, welches später in einer Nachverarbeitung mit dem Faktor des ausgewählten Verstärkungsfaktors wieder multipliziert wird, um mit dem realistischen Signal weiterarbeiten zu können.

Zur Erhöhung einer stabilen Funktion wird der Zeitpunkt des Umschaltens auf einen niedrigeren Verstärkungsfaktor begrenzt, vorzugsweise durch ein eingeschränktes Zeitfenster nach Anspruch 6.

Des weiteren wird vorgeschlagen, dass jedesmal, wenn ein Schaltvorgang auf einen anderen Verstärkungsvorgang stattfindet, ein Reset des Verstärkers vorgenommen wird. Auf diese Weise können Störspannungen, die beim Schalten unvermeidbar sind, eliminiert werden. Die aufsummierten Spannungen werden rechnerisch verarbeitet.

Wenn CMOS-Technik eingesetzt wird, lässt sich der Ausleseverstärker in unmittelbarer Nähe zu einem das Eingangssignal liefernden Photosensor (Pixel) des Computertomographen anordnen.

Nachfolgend wird die Erfindung anhand der Figuren näher erläutert:

Es zeigen:
- Figur 1: die logarithmierte Anzahl der Röntgenphotonen und des Rauschens in Bit als Funktion der übertragenen Photonen;
- Figur 2: ein prinzipielles Schaltbild eines zweistufigen Ausleseverstärkers mit automatischer Steuerung des Verstärkungsfaktors;
- Figur 3: in tabellarischer Form eine Zifferstandzählmethode zur Umschaltung der Verstärkungsfaktoren.

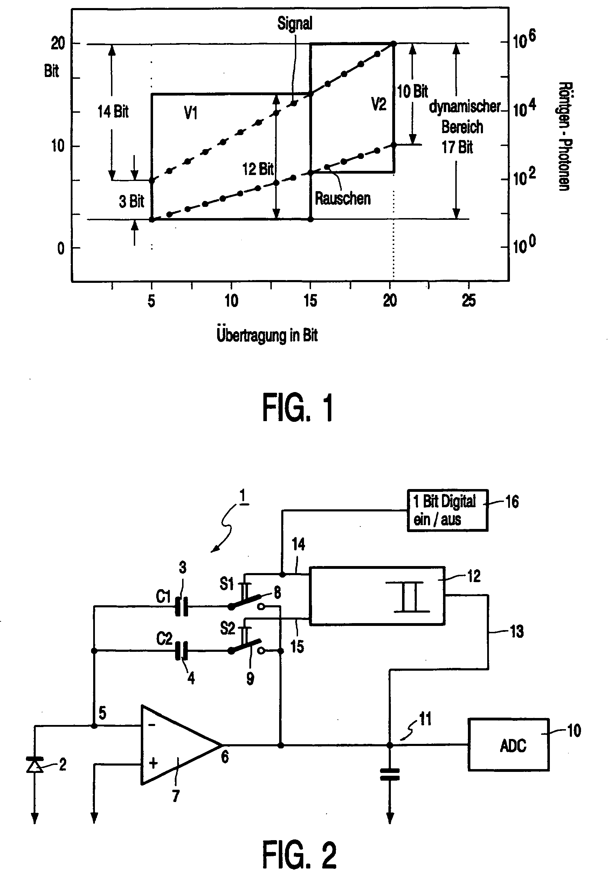

Figur 1 zeigt den dynamischen Bereich eines quantenbegrenzten Detektorsystems, bei dem die Auflösung nicht durch das elektrische Rauschen, sondern infolge der statistischen Abweichungen der Eingangssignale begrenzt wird. Figur 1 verdeutlicht, dass die Anzahl Röntgenphotonen um einen Faktor 16.000 ausgehend von dem niedrigsten Signal (etwa 64 Photonen) bis zu dem höchsten Signal (etwa eine Million Photonen) schwankt. Dies entspricht nach Anzahl der benötigten Binärzahlen etwa 14 Bit.

Am Beispiel des niedrigsten Signals wird das Verhältnis von Signalhöhe und Rauschen erklärt. Das niedrigste Signal entspricht 2⁶ Photonen. Zu seiner Darstellung werden 6 Bit benötigt. Das Rauschen des Signals, das ebenfalls zu verarbeitende Informationen enthält, ergibt sich aus dessen Quadratwurzel. Für das Rauschen des Signals werden demnach 3 Bit benötigt. Bei einem Signal mit 28 Photonen werden 8 Bit, für das Rauschen dieses Signals 4 Bit benötigt. Dieses Verhältnis setzt sich in Abhängigkeit von der Quadratwurzelfunktion fort.

Die Auflösung des Signals ist daher von dessen Höhe abhängig. Für das höchste in Figur 1 dargestellte Signal beträgt das Verhältnis des Signals zum Rauschen 10 Bit, während für das kleinste Signal das Verhältnis von Signal zu Rauschen lediglich 3 Bit beträgt, d.h. bei kleineren Signalen ist der negative Rauscheffekt geringer.

Aus Figur 1 ist erkennbar, dass ein globaler dynamischer Bereich von 17 Bit erforderlich ist, um eine Verstärkung des kleinsten Rauschsignals (8 Photonen) und des höchsten Signals (etwa eine Million Photonen) sicherzustellen. Die praktisch verfügbaren Analog-Digital-Wandler haben aber Schwierigkeiten, einen derartig hohen globalen dynamischen Bereich bei gleichzeitig hoher Geschwindigkeit aufzubringen. Üblicherweise sind sie für maximal 12-14 Bit ausgelegt. Erfindungsgemäß wird daher auf einen Ausleseverstärker mit mehreren Verstärkungsfaktoren zurückgegriffen, der in Abhängigkeit der Höhe der integrierten Ladungsmenge einen geeigneten Verstärkungsfaktor wählt und somit die Bitzahl verkleinert. Dies geschieht nach der Erfindung dadurch, dass eine schrittweise lineare Approximation an eine Wurzelfunktion stattfindet. Jede Verstärkungsstufe mit dem ihr eigenen Verstärkungsfaktor deckt einen lokalen dynamischen Bereich ab, der kleiner ist als der globale dynamische Bereich des Analog-Digital-Wandlers. Dies wird in Figur 1 durch die Aufteilung in zwei Blockbereiche mit einem Verstärkungsfaktor 1 und 2 verdeutlicht. Steigt das aufsummierte Signal auf einen Wert oberhalb von 2¹² Photonen, d.h. 12 Bit, an, wird auf den Verstärkungsfaktor V2 umgeschaltet, der mit einem niedrigeren Faktor die notwendige Bitzahl reduziert. Dies bewirkt beispielsweise bei dem höchsten Signal von 10⁶ Photonen, dass nicht 20 Bit für das Signal, sondern nur noch 10 Bit zur Verarbeitung notwendig sind.

Ein Ausführungsbeispiel eines Schaltbildes für einen zweistufigen Ausleseverstärker für einen Röntgenstrahl-Detektor ergibt sich aus der Figur 2. Der insgesamt mit 1 bezeichnete Ausleseverstärker integriert das von einem Sensorelement 2, hier eine Photodiode, kommende Eingangssignal auf Rückkoppelkapazitäten 3 und 4. Das Eingangssignal ist proportional zur Anzahl der von der jeweiligen Photodiode empfangenen Röntgenphotonen. Die Rückkoppelkapazitäten sind parallel zu einem invertierenden Eingang 5 und einem Ausgang 6 eines Operationsverstärkers 7 über Schalter 8 und 9 geschaltet. Der Verstärker 1 ist mit einem Analog-Digital-Wandler 10 verbunden, der das Ausgangssignal des Verstärkers in ein digitales Signal umwandelt.

Durch eine Integration der Ladung auf den Rückkoppelkapazitäten 3, 4 wird eine Ausgangsspannung erzeugt, die proportional zur Anzahl der Röntgenphotonen während eines Frames bzw. Bildaufnahme ist. Dabei verhält sich die Ausgangsspannung reziprok zur Größe der Rückkoppelkapazitäten. Durch geeignete Wahl der Größe der Kapazitäten lässt sich für ein bestimmtes Intervall bis zu einem bestimmten Ladungsgrenzwert eine lineare Näherung an die gewünschte Wurzelfunktion erreichen. Jeder Frame endet mit der Übertragung der Ausgangsspannung zu einer Sample- and Hold-Stufe 11. Die Ausgangsspannung der Sample- and Hold-Stufe 11 an deren Ausgang nach einem Frame ist ein direktes Maß für die Anzahl der Röntgenphotonen.

Bei der vorliegenden Ausführungsform beginnt die Integrierung der Ladung mit einem hohen Verstärkungsfaktor V1. Hierzu ist der Schalter S1 bzw. 8 geschlossen und der Schalter S2 bzw. 9 geöffnet. Das Eingangssignal wird auf der Rückkopplungskapazität 3 integriert. Die Ausgangsspannung steigt an. Die Kapazität des Kondensators ist dabei so gewählt, dass die Ausgangsspannung der Wurzelfunktion angenähert ist. Die derart verstärkten Ausgangssignale werden in der Sample- und Hold-Stufe 11 gespeichert und mittels eines Komparators 12 über eine Steuerleitung 13 mit einem Vergleichswert verglichen. Ist eine vorgegebene maximale Ausgangsspannung erreicht, die beispielsweise nach Figur 1 12 Bit entspricht, entscheidet der Komparator 12, dass ein niedrigerer Verstärkungsfaktor V2 gewählt wird. Hierzu wird über die Steuerleitung 15 der zweite Rückkopplungskondensator 4 parallel zu dem ersten Rückkopplungskondensator mit der Steuerleitung 14 geschaltet, indem der Schalter S2 bzw. 9 geschlossen wird. Der Gesamtrückkopplungskondensator ergibt sich nun aus der Summe der beiden Kapazitäten C1 und C2. Insgesamt wird der Verstärkungsfaktor niedriger. Durch diese lineare Verkleinerung des Verstärkungsfaktors wird eine Anpassung an die bei größeren Bitzahlen immer geringer wachsende Wurzelfunktion erreicht.

Neben dem analogen Ausgang an der Sample- und Hold-Stufe 11 besitzt der Ausleseverstärker 1 einen digitalen Ausgang 16, der die Kontrollinformation über den gewählten Verstärkungsfaktor liefert. Im Ausführungsbeispiel mit zwei Verstärkungsfaktoren genügt hierfür ein Bit. Durch diese Ausführungsform ergibt sich eine gemischte analoge/digitale Verarbeitung der Signale.

Nachfolgend wird die zweite Ausführungsform auf Basis einer zählerstandabhängigen Umschaltung nach der rein digitalen Lösung näher beschrieben. Die Ausgangsspannung, die mit einem entsprechenden Grenzwert verglichen wird, wird hierbei nach der Zählmethode in einen Ziffernwert umgewandelt. Nach einer bekannten Methode wird hierzu auf einen Rückkopplungskondensator integriert. Wenn die Ausgangsspannung einen maximalen vorgegebenen Wert erreicht, wird der Kondensator zurückgesetzt. Jeder Reset entspricht einem Ziffernwert. Die Anzahl der Resetvorgänge werden summiert. Nach dem letzten Frame entspricht die Ziffer als digitales Signal der Anzahl der vorgenommenen Resetvorgänge und ist somit ein Maß für das analoge Signal.

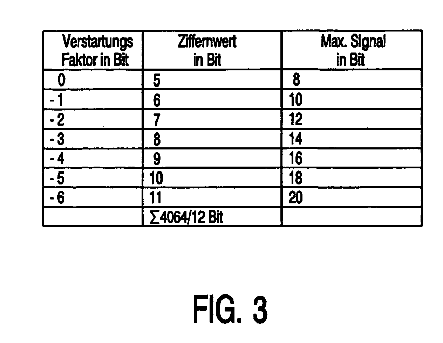

Um eine Anpassung des jeweiligen Ziffernwertes durch einen entsprechenden Verstärkungsfaktor zu erreichen und somit eine Reduzierung der Bitzahl zur Verarbeitung des digitalen Signals, erfolgt eine schrittweise lineare Reduzierung des Ziffernwertes. Nach dem Beispiel in Figur 3 (Tabelle 1) beginnt die Integration mit einem Verstärkungsfaktor 0 und einem Komparator, die sich an dem Rauschen des kleinsten Signals orientieren. Durch Aufsummieren der Ladungen und somit der Abfolge von Reset-Vorgängen wächst der Ziffernwert so lange, bis er beispielsweise einen Faktor erreicht hat, der viermal größer als das minimale Signal ist. Dieser Ziffernwert entspricht einer Bitzahl von 5. Dieser Ziffernwert entspricht wiederum einem maximalen Signal von 8 Bit, d. h. 2⁸ Photonen. Wenn 5 Bit erreicht sind, wird der Verstärkungsfaktor reduziert. Dies wird mittels der aus Figur 2 bekannten Schaltungselemente erreicht, indem eine erste Kapazität mit einer zweiten Kapazität parallel geschlossen werden.

In einem zweiten Schritt wächst der Ziffernwert an, nun aber langsamer, da der Verstärkungsfaktor niedriger ist. Der zweite Schritt ist beendet, wenn ein Ziffernwert erreicht ist, der 6 Bit oder einem Signal von 10 Bit oder 2¹⁰ Photonen entspricht. In einem dritten Schritt wird der Verstärkungsfaktor wieder um einen entsprechenden Faktor reduziert und die Aufsummierung des Ziffernwertes so lange fortgesetzt, bis ein entsprechender Wert erreicht ist, der 7 Binärzahlen benötigt. Diese Zählweise wird solange wiederholt, bis der gesamt dynamische Bereiche gescannt ist. Aus Figur 3 ist zu entnehmen, dass das höchste Signal mit etwa 1 Million Photonen oder 2²⁰ Bit nach der vorgeschlagenen Methode einem Ziffernwert in 11 Bit entspricht.

Figur 3 zeigt die beschriebene Abfolge der Vestärkungsfaktoren, der Ziffernwerte in Bit sowie der maximalen Signale in Bit, die durch die lineare Verstärkung reduziert worden sind. Insgesamt wird ein dynamischer Bereich von 17 Bit auf die Verarbeitung von 12 Bit beschränkt.

Nach einer Weiterbildung der digitalen Zählmethode kann diese wiederum mit analogen Signalen kombiniert werden. In Anpassung an die Zählmethode nach Figur 1 sind hier entsprechende Zählmethoden denkbar.

## Patentansprüche

1. Computertomograph mit einer Strahlungsquelle, einer Detektoranordnung (2), einem Analog-Digital-Wandler (10) zum Umsetzen der Detektorausgangssignale in Digitalwerte, und einen dem Analog-Digital-Wandler (10) vorgeordneten Ausleseverstärker (1), **dadurch gekennzeichnet, dass** der Ausleseverstärker (1) mehrere Verstärkungsfaktoren hat und ein Steuersystem (12) für den jeweiligen Verstärkungsfaktorhat, das automatisch bei Erreichen eines vorgegebenen Grenzwertes des integrierten Eingangssignals einen geeigneten jeweils niedrigeren Verstärkungsfaktor wählt zur schrittweisen linearen Approximierung an ein proportionales Verhältnis zwischen den Digitalwerten und der Quadratwurzel der Detektorausgangssignale

2. Computertomograph nach Anspruch 1, wobei der Verstärkungsfaktor so gewählt wird, dass in dem jeweiligen Intervall das Rauschen des jeweils kleinsten Signals noch erfasst wird und dass die Bitzahl des jeweils größten Signals die Bitzahl, die durch den Analog-Digital-Wandler (10) noch zu verarbeiten ist, nicht überschreitet.

3. Computertomograph nach Anspruch 1, wobei die Ventärker-Eingassignale als analoge Signale aufsummiert werden und dass das Steuersystem (12) bei Erreichen eines vorgegebenen maximalen Grenzwertes der Ausgangsspannung auf einen jeweils niedrigeren Verstärkungsgrad umschaltet.

4. Computertomograph nach Anspruch 3, wobei ein digitales Signal (16) die Kontrollinformation über den gewählten Verstärkungsfaktor liefert zur Rückmultiplizierung des im Verstärker(1) reduzierten Signals während einer Nachbearbeitungsstufe.

5. Computertomograph nach Anspruch 3, wobei
• der ladungsintegrierende Ausleseverstärker (1) einen Operationsverstärker (7) mit einem invertierenden Eingang (5), einem nicht-in-veitierenden Eingang und einen Ausgang (6) sowie mehrere parallel zu dem Operationsverstärker zwischen dem invertierenden Eingang (5) und dem Ausgang (6) des Operationsverstärkers (7) mit Schaltmitteln (8, 9) schaltbare Kondensatoren (3, 4) umfasst,
• die Steuerung (12) einen Komparator (12) zum Vergleich und Steuerung der Schaltmittel (8, 9) aufweist, wobei der Komparator (12) das integrierte Eingangssignal des Ausleseverstärkers (1) mit dem vorgegebenen Ladungsgrenzwert vergleicht und den Befehl zum Betätigen der Schaltmittel (8, 9) auf einen niedrigeren Verstärkungsfaktor gibt, wenn der Ladungsgrenzwert überschritten ist,
• die Kapazitäten der parallel geschalteten Kondensatoren so gewählt sind, dass über den jeweils resultierende Gesamtverstärkungsfaktor die resultierende lineare Verstärkung im entsprechenden Integrationsintervall der Wurzelfunktion angenähert ist und
• der jeweils gewählte Verstärkungsfaktor in Form einer Kontrollinformation (16) gespeichert und weiterverarbeitet wird.

6. Computertomograph nach Anspruch 1, bei dem der Umschaltzeitpunktauf einen niedrigeren Verstärkungsfaktor durch ein eingeschränktes Zeitfenster der Gesamtintegrationszeit begrenzt ist.

7. Computertomograph nach Anspruch 1, wobei die Verstärker-Eingangssignale als Ziffernwert aufsummiert werden, indem der ladungsintegrierende Verstärker bei Erreichen eines maximalen Grenzwertes für die Ausgangsspannung in die Nullstellung zurückgesetzt wird und die Anzahl der Resetvorgänge den Ziffernwert ergibt, und dass ein Komparator bei Erreichen eines vorgegebenen jeweils maximalen Ziffernwertes auf einen jeweils niedrigeren Verstärkungsfaktor umschaltet.

8. Computertomograph nach einem der Ansprüche 1 bis 7, wobei der Verstärker(1) und der Analog-Digital-Wandler(10) vollständig in CMOS-Technik aufgebaut sind.

## Claims

1. A computed tomography apparatus which includes a radiation source, a detector device (2) and an analog-to-digital converter (10) for converting the detector output signals into digital values, and a read-out amplifier (1) arranged preceding the analog-to-digital converter (10), **characterized in that** the read-out amplifier (1) which precedes the analog-to-digital converter (10) and has a plurality of gain factors and a control system (12) for the respective, gain factor which, when a predetermined limit value of the integrated input signal is reached, automatically selects an appropriate, each time lower gain factor for the step-wise linear approximation of a proportional ratio between the digital values and the square root of the detector output signals.

2. A computed tomography apparatus as claimed in claim 1, **characterized in that** the gain factor is chosen to be such that the noise of the respective smallest signal is still detected in the relevant interval and that the number of bits of the respective largest signal does not exceed the number of bits that can still be processed by the analog-to-digital converter (10).

3. A computed tomography apparatus as claimed in claim 1, **characterized in that** the amplifier input signals are summed as analog signals and that the control system (12) switches over to a respective lower degree of gain when a predetermined maximum limit value of the output voltage is reached.

4. A computed tomography apparatus as claimed in claim 3, **characterized in that** a digital signal (16) provides the control information concerning the selected gain factor for the re-multiplication, during a post-processing step, of the signal reduced in the amplifier (1).

5. A computed tomography apparatus as claimed in claim 3, **characterized in that**
- the charge integrating read-out amplifier (1) includes an operational amplifier (7) with an inverting input (5), a non-inverting input and an output (6) as well as a plurality of capacitors (3, 4) which can be connected parallel to the operational amplifier between the inverting input (5) and the output (6) of the operational amplifier (7), by means of switching means (8, 9),
- the control system (12) includes a comparator (12) for the comparison and control of the switching means (8, 9), the comparator (12) comparing the integrated input signal of the read-out amplifier (1) with the predetermined charge limit value and issues the command for the switching means (8, 9) to switch over to a lower gain factor when the charge limit value is exceeded,
- the capacitances of the parallel connected capacitors are chosen to be such that via the respective resultant overall gain factor the resulting linear amplification approximates the root function in the relevant integration interval, and
- the respective gain factor chosen is stored as control information (16) and further processed.

6. A computed tomography apparatus as claimed in claim 1, **characterized in that** the instant of switching over of the switching means to a lower gain factor is restricted to a limited time window of the overall integration time.

7. A computed tomography apparatus as claimed in claim 1, **characterized in that** the amplifier input signals are summed as numerical values **in that** the charge integrating amplifier is reset to the zero position when a maximum limit value is reached for the output voltage and the number of reset operations yields the numerical value, and that a comparator switches over to a respective lower gain factor when a predetermined, each time maximum numerical value is reached.

8. A computed tomography apparatus as claimed in any one of the claims 1 to 7, **characterized in that** the amplifier and the analog-to-digital converter are constructed completely by means of CMOS technology.

## Revendications

1. Tomographe informatisé avec une source de rayonnement, un dispositif détecteur (2), un convertisseur analogique/numérique (10) pour la conversion des signaux de sortie du détecteur en valeurs numériques et un amplificateur de lecture (1) monté en aval du convertisseur analogique/numérique (10), **caractérisé en ce que** l'amplificateur de lecture (1) a plusieurs facteurs d'amplification et un système de commande (12) pour le facteur d'amplification respectif qui sélectionne automatiquement un facteur d'amplification respectivement inférieur adéquat lorsqu'une valeur-limite préalablement déterminée du signal d'entrée intégré est atteinte en vue de l'approximation linéaire progressive à un rapport proportionnel entre les valeurs numériques et les racines carrées des signaux de sortie du détecteur.

2. Tomographe informatisé selon la revendication 1, dans lequel le facteur d'amplification est choisi de telle sorte que le bruit du signal respectivement minimal soit encore enregistré dans l'intervalle respectif et que le nombre de bits du signal respectivement maximal ne dépasse pas le nombre de bits qui doit encore être traité par le convertisseur analogique/numérique (10).

3. Tomographe informatisé selon la revendication 1, dans lequel les signaux d'entrée de l'amplificateur sont additionnés comme des signaux analogiques et que le système de commande (12) commute à un degré d'amplification respectivement inférieur lors une valeur-limite maximale préalablement déterminée de la tension de sortie est atteinte.

4. Tomographe informatisé selon la revendication 3, dans lequel un signal numérique (16) délivre l'information de contrôle par l'intermédiaire du facteur d'amplification sélectionné en vue d'une nouvelle multiplication du signal réduit dans l'amplificateur (1) pendant une étape de post-traitement.

5. Tomographe selon la revendication 3, dans lequel
• l'amplificateur de lecture (1) à intégration de charge comprend un amplificateur d'opération (7) avec une entrée inversante (5), une entrée non-inversante et une sortie (6) ainsi que plusieurs condensateurs (3, 4) à monter parallèlement à l'amplificateur d'opération entre l'entrée inversante (5) et la sortie (6) de l'amplificateur d'opération (7) avec des moyens de commutation (8, 9),
• la commande (12) présente un comparateur (12) pour la comparaison et la commande des moyens de commutation (8, 9), le comparateur (12) compare le signal d'entrée intégré de l'amplificateur de lecture (1) avec la valeur-limite de charge préalablement déterminée et donnant l'ordre d'actionner les moyens de commutation (8, 9) sur un facteur d'amplification inférieur lorsque la valeur limite de charge est dépassée,
• les capacités des condensateurs montés parallèlement sont sélectionnées de telle sorte que l'amplification linéaire en résultant dans l'intervalle d'intégration correspondant de la fonction de racine soit approchée par l'intermédiaire du facteur d'amplification total en résultant et
• le facteur d'amplification respectivement sélectionné est enregistré et traité sous la forme d'une information de contrôle (16).

6. Tomographe informatisé selon la revendication 1, dans lequel le moment de commutation est limité à un facteur d'amplification inférieur par une fenêtre temporelle limitée du temps intégration total.

7. Tomographe informatisé selon la revendication 1, dans lequel les signaux de sortie de l'amplificateur sont additionnés comme une valeur chiffrée en réinitialisant l'amplificateur à intégration de charge dans la position lorsqu'une valeur limite maximale est atteinte pour la tension de sortie et le nombre des processus de réinitialisation donne la valeur chiffrée et qu'un comparateur commute sur un facteur d'amplification respectivement inférieur lorsqu'qu'une valeur chiffrée respectivement maximale préalablement déterminée est atteinte.

8. Tomographe informatisé selon l'une des revendications 1 à 7, dans lequel l'amplificateur (1) et le convertisseur analogique/numérique (10) sont conçus totalement dans la technique CMOS.
